# EUROPEAN PATENT APPLICATION

(11) **EP 4 089 212 A1**
(43) Date of publication of application: **16.11.2022**
(21) Application number: 20913026.9
(22) Date of filing: 03.12.2020
(51) Int. Cl.: C30B 29/38, C23C 16/34, C30B 25/20, H01L 21/205

(54) **METHOD FOR MANUFACTURING GROUP III NITRIDE SUBSTRATE, AND GROUP III NITRIDE SUBSTRATE**

(30) Priority: 10.01.2020 JP 2020002945
(71) Applicant: Shin-Etsu Chemical Co., Ltd., Tokyo 100-0005 (JP)
(72) Inventor: KUBOTA, Yoshihiro, Annaka-shi, Gunma 379-0195 (JP); NAGATA, Kazutoshi, Annaka-shi, Gunma 379-0195 (JP)
(74) Representative: Vossius & Partner Patentanwälte Rechtsanwälte mbB
(86) International application number: PCT/JP2020/045027
(87) International publication number: WO 2021/140793

(57) **Abstract**

The method for manufacturing a group III nitride substrate of the present invention includes: a step of forming group III nitride films having a group III element face on a surface thereof, on both surfaces of a substrate, so as to produce a group III nitride film carrier; a step of performing ion implantation to the group III nitride film of the group III nitride film carrier, so as to form an ion-implanted region in the group III nitride film; a step of adhering the group III nitride film having been subjected to the ion implantation to a base substrate containing polycrystals containing a group III nitride as a major component, so as to bond the group III nitride film carrier to the base substrate; a step of spacing the group III nitride film carrier from the base substrate to transfer the ion-implanted region to the base substrate, so as to form a group III nitride film having an N face on a surface thereof on the base substrate; and a step of forming a group III nitride film on the group III nitride film having an N face on a surface thereof on the base substrate by a THVPE method, so as to produce a thick film of a group III nitride film. The group III nitride substrate of the present invention is manufactured by the method for the manufacturing a group III nitride substrate of the present invention. According to the present invention, a method for manufacturing a group III nitride substrate that is capable of manufacturing a group III nitride substrate having a large diameter and a high quality, and a group III nitride substrate that is manufactured by the manufacturing method can be provided.

## Description

### Technical Field

The present invention relates to a method for manufacturing a group III nitride substrate, and a group III nitride substrate manufactured by the manufacturing method.

### Background Art

A group III nitride substrate, such as a crystalline GaN-based nitride substrate and an AlN-based nitride substrate, has a wide band gap, a light emission capability of an ultra high frequency, a high breakdown voltage, and excellent high frequency characteristics. Due to the features, a group III nitride substrate is expected to have applications to devices, such as a laser device, a schottky diode, a power device, and a high frequency device. However, the current situation is that the group III nitride substrate is expensive due to the difficulty in crystal growth of a group III nitride to a thick film (large length) having a large diameter and a high quality, inhibiting the application expansion and the widespread use of the substrate.

For example, as for a GaN substrate, a bulk GaN substrate formed by growing a GaN crystal in a liquid, such as liquid ammonia or a Na flux, generally has a relatively high quality. However, a high temperature and high pressure equipment is required therefor, and therefor the size thereof (i.e., a large diameter and a large thickness) is difficult to increase. On the other hand, a large size substrate, i.e., a substrate having a large size and a high quality, can be manufactured in principle through heteroepitaxial growth or homoepitaxial growth of GaN on a single crystal substrate, such as a sapphire substrate, a GaAs substrate, a SiC substrate, a SCAM (ScAlMgO₄) substrate, a GaN substrate, or an AlN substrate, by using a metal organic chemical vapor deposition method (MOCVD method) or a hydride vapor phase epitaxy method (such as an HVPE method and a THVPE method), which perform crystal growth in a vapor phase. However, in practical, only a small size substrate is currently manufactured for a single crystal substrate that is the same as or relatively close to a GaN crystal in lattice constant and thermal expansion coefficient, such as a GaN substrate and a SCAM substrate, and therefore it is difficult to increase the size through the epitaxial film formation due to the absence of a large single crystal substrate.

As a countermeasure therefor, NPL 1 describes that plural tiled substrates obtained by cutting out a GaN single crystal obtained through the Na flux method in a honeycomb shape are adhered on a pyrolytic graphite (PG) susceptor to enlarge the GaN single crystal, and using the enlarged GaN single crystal as a seed substrate, GaN is grown thereon by the HVPE method or the like to provide a large size GaN substrate. PTL 1 describes that plural tiled substrates obtained by cutting out a GaN single crystal obtained through a known method, such as a vapor phase method, in a honeycomb shape are adhered on a pyrolytic graphite (PG) susceptor to enlarge the GaN single crystal, and using the enlarged GaN single crystal as a seed substrate, GaN is grown thereon by the HVPE method or the like to provide a large size GaN substrate. In these methods, however, there are large differences in thermal expansion coefficient among the PG susceptor, which can be considered as the base substrate, the alumina-based adhesive or the zirconia-based adhesive for adhering the PG susceptor to the seed substrate, and the tiled GaN single crystal or SCAM single crystal as the seed substrate, and thereby migration, exfoliation, warpage, and the like of the seed substrate occur due to the expansion and contraction through temperature change, and the crystallographic orientation and the plane identity are difficult to retain during the film forming reaction period, resulting in difficulty in forming a film having uniform orientation.

On the other hand, there have been attempts of the manufacture of a large size GaN substrate by using a single crystal substrate that is relatively easily available as a large diameter product, such as a Si substrate, a sapphire substrate, a SiC substrate, a GaAs substrate, and a SCAM (ScAlMgO₄) substrate, as both the base substrate and the seed substrate. However, there are large inconsistencies in lattice constant and thermal expansion coefficient between the single crystal substrate and the GaN crystal, by which a GaN substrate obtained through epitaxial film formation has various defects occurring and increasing therein, and also undergoes warpage and cracking, which cause problems.

As one solution therefor, there have been proposals in which GaN or AlN polycrystalline powder, powder having a mullite composition as described in PTL 2, or the like, which has the same or approximate lattice constant and thermal expansion coefficient, is added with a sintering aid and sintered to form ceramics, and using the resulting ceramics as a base substrate, a single crystal thin film, such as a Si substrate, a sapphire substrate, a SiC substrate, a GaAs substrate, a GaN substrate, or an AlN substrate, is transferred and adhered on the base substrate, and using the assembly as a seed substrate, GaN is heteroepitaxially grown on the seed substrate to provide a large size GaN substrate. In this method, however, metal impurities derived from the ceramics raw material, the sintering aid, or the like are diffused to cause contamination during the epitaxial film formation of GaN, resulting in difficulty in formation of a substrate having high characteristics.

As one improvement measure, PTL 3 describes a proposal in which using AlN ceramics having a thermal expansion coefficient relatively close to GaN as a base substrate, after sealing the entire substrate by enclosing with a multilayer film of an inorganic material, such as Si, SiO₂, or Si₃N₄, and further stacking SiO₂ thereon, a Si <111> thin film as a seed substrate is transferred and adhered thereon, and then a GaN film is epitaxially formed while preventing metal impurities from being diffused from the base substrate. However, many processes are required for sealing by enclosing with the multilayer inorganic material, resulting in an uneconomical high cost, and furthermore it is significantly difficult to secure the complete sealing with the multilayer film.

### Citation List

### Patent Literatures

PTL 1: Japanese Patent No. 6203460
PTL 2: Japanese Patent No. 6331553
PTL 3: U.S. Patent No. 9,997,391 B2

### Non-patent Literature

NPL 1: Phys. Status Solidi B, 254, No. 8, 1600671 (2017)

### Summary of Invention

### Technical Problem

The present invention has been made in view of the aforementioned circumstances, and an object thereof is to provide a method for manufacturing a group III nitride substrate that is capable of manufacturing a group III nitride substrate having a large diameter and a high quality, and a group III nitride substrate that is manufactured by the manufacturing method.

### Solution to Problem

For achieving the object, the present invention provides a method for manufacturing a group III nitride substrate and a group III nitride substrate manufactured by the manufacturing method shown below. Specifically, the present invention relates to the following.
[1] A method for manufacturing a group III nitride substrate, including: a step of forming group III nitride films having a group III element face on a surface thereof, on both surfaces of a substrate selected from the group consisting of a Si <111> substrate, a sapphire substrate, a SiC substrate, a GaAs substrate, and a SCAM (ScAlMgO₄) substrate, so as to produce a group III nitride film carrier; a step of performing ion implantation to the group III nitride film on at least one surface of both surfaces of the group III nitride film carrier, so as to form an ion-implanted region; a step of adhering the group III nitride film having been subjected to the ion implantation of the group III nitride film carrier to a base substrate containing polycrystals containing a group III nitride as a major component, so as to bond the group III nitride film carrier to the base substrate; a step of spacing the group III nitride film carrier from the base substrate to transfer the ion-implanted region of the group III nitride film to the base substrate, so as to form a group III nitride film having an N face on a surface thereof on the base substrate; and a step of forming a group III nitride film on the group III nitride film having an N face on a surface thereof on the base substrate by a THVPE method, so as to produce a thick film of a group III nitride film.
[2] The method for manufacturing a group III nitride substrate according to the item [1], wherein the group III nitride film having a group III element face on a surface thereof is a GaN film having a Ga face on a surface thereof.
[3] The method for manufacturing a group III nitride substrate according to the item [1] or [2], wherein the base substrate is a polycrystalline GaN (P-GaN) substrate.
[4] The method for manufacturing a group III nitride substrate according to any one of the items [1] to [3], wherein the group III nitride film formed on the group III nitride film having an N face on a surface thereof on the base substrate is a GaN film.
[5] The method for manufacturing a group III nitride substrate according to any one of the items [1] to [4], wherein the base substrate is a substrate that is obtained by forming the polycrystals on a PBN substrate by a vapor phase epitaxy method.
[6] The method for manufacturing a group III nitride substrate according to the item [5], wherein the vapor phase epitaxy method is a THVPE method.
[7] The method for manufacturing a group III nitride substrate according to any one of the items [1] to [6], wherein the step of producing the group III nitride film carrier includes forming the group III nitride films having a group III element face on a surface thereof, on both surfaces of the substrate to have thicknesses that are substantially the same as each other, by an MOCVD method, and the group III nitride film carrier produced by the step of producing the group III nitride film carrier has a curvature radius of 10 m or more.
[8] A group III nitride substrate that is manufactured by the method for manufacturing a group III nitride substrate according to any one of the items [1] to [7].

### Advantageous Effects of Invention

According to the present invention, a method for manufacturing a group III nitride substrate that is capable of manufacturing a group III nitride substrate having a large diameter and a high quality, and a group III nitride substrate that is manufactured by the manufacturing method can be provided.

### Brief Description of Drawings

Fig. 1 is an illustration for describing the reaction apparatus used in the production of the base substrate and the formation of the crystal on the seed substrate in Example 1.
Fig. 2 is an illustration for describing the reaction apparatus used in the production of the base substrate and the formation of the crystal on the seed substrate in Example 1.

### Description of Embodiments

### [Method for manufacturing Group III Nitride Substrate]

The method for manufacturing a group III nitride substrate of the present invention includes: a step (A) of forming group III nitride films having a group III element face on a surface thereof, on both surfaces of a substrate selected from the group consisting of a Si <111> substrate, a sapphire substrate, a SiC substrate, a GaAs substrate, and a SCAM (ScAlMgO₄) substrate, so as to produce a group III nitride film carrier; a step (B) of performing ion implantation to the group III nitride film on at least one surface of both surfaces of the group III nitride film carrier, so as to form an ion-implanted region in the group III nitride film; a step (C) of adhering the group III nitride film having been subjected to the ion implantation of the group III nitride film carrier to a base substrate containing polycrystals containing a group III nitride as a major component, so as to bond the group III nitride film carrier to the base substrate; a step (D) of spacing the group III nitride film carrier from the base substrate to transfer the ion-implanted region of the group III nitride film to the base substrate, so as to form a group III nitride film having an N face on a surface thereof on the base substrate; and a step (E) of forming a group III nitride film on the group III nitride film having an N face on a surface thereof on the base substrate by a THVPE method (trihalide vapor phase epitaxy method). According to the procedure, a group III nitride substrate having a large diameter and a high quality can be manufactured. The steps of the method for manufacturing a group III nitride substrate of the present invention will be described below.

### Step (A)

In the step (A), group III nitride films having a group III element face on the surface thereof are formed on both surfaces of a substrate selected from the group consisting of a Si <111> substrate, a sapphire substrate, a SiC substrate, a GaAs substrate, and a SCAM (ScAlMgO₄) substrate, so as to produce a group III nitride film carrier. In this step, a group III nitride seed crystal having a large diameter having a group III element face on the surface thereof is produced. In this step, the substrate selected from the group consisting of a Si <111> substrate, a sapphire substrate, a GaAs substrate, a SiC substrate, and a SCAM (ScAlMgO₄) substrate, which has a crystal form close to the group III nitride seed crystal, has a lattice constant relatively close to the lattice constant of the group III nitride seed crystal, and can readily provide a substrate having a large diameter, is used. According to the procedure, a group III nitride substrate having a large diameter can be manufactured. The group III nitride films having a group III element face on the surface thereof are formed on both surfaces of the substrate, preferably through vapor phase epitaxy.

The group III nitride film having a group III element face on the surface thereof can be obtained by an ordinary vapor phase epitaxy method, such as MOCVD (metal organic chemical vapor deposition method) and HVPE (hydride vapor phase epitaxy method). The substrate used may be appropriately selected from the aforementioned substrates depending on the lattice constant of the target group III element face of the group III nitride seed crystal, the availability of the substrate having a large diameter, the cost thereof, and the like. It is preferred that on both surfaces of the selected substrate, the target group III nitride films having a group III element face on the surface thereof are formed to have thicknesses that are substantially the same as each other by a vapor phase epitaxy method, such as MOCVD and HVPE. The resulting group III nitride film is used as a seed crystal for forming a group III nitride film in the step (E) described later, and therefore the group III nitride film is more preferably formed by the MOCVD method, which can provide a group III nitride film having good crystal characteristics among the vapor phase epitaxy methods. In the MOCVD method, for example, the process gas used may be trimethylgallium (TMG) or triethylgallium (TEG) and ammonia (NH₃), and the carrier gas used may be nitrogen (N₂), hydrogen (H₂), or the like.

The thickness of the group III nitride film is preferably 0.5 µm or more for facilitating the formation of a good seed crystal in the step (E) described later. The thicknesses of the group III nitride films are preferably substantially the same as each other between the front surface and the back surface for reducing the warpage of the group III nitride film carrier. For example, the difference between the thickness of the group III nitride film formed on one surface of the substrate and the thickness of the group III nitride film formed on the other surface of the substrate is preferably 0.5 µm or less, more preferably 0.3 µm or less, and further preferably 0.1 µm or less, and it is particularly preferred that the thickness of the group III nitride film formed on one surface of the substrate and the thickness of the group III nitride film formed on the other surface of the substrate are same as each other. The group III nitride films having a group III element face on the surface thereof are formed on both surfaces of the substrate since the formation of the film only on one surface may cause a large warpage or cracks in the group III nitride film carrier in some cases due to the difference in thermal expansion coefficient between the substrate and the group III nitride film. The formation of the group III nitride films on both surfaces of the substrate to have thicknesses that are same as each other prevents the aforementioned phenomena from occurring, and facilitates the batch transfer of the group III nitride film to the flat base substrate.

The curvature radius of the group III nitride film carrier is preferably 10 m or more, and more preferably 20 m or more. In the case where the curvature radius of the group III nitride film carrier is 10 m or more, the thin film transfer in the steps (C) and (D) described later can be easily performed due to the small warpage of the substrate.

Examples of the group III nitride film having a group III element face on the surface thereof include an AlN film having an Al face on the surface thereof, a GaN film having an Ga face on the surface thereof, and an InN film having an In face on the surface thereof. The method for manufacturing a group III nitride substrate of the present invention can particularly favorably manufacture a GaN substrate, and therefore the group III nitride film having a group III element face on the surface thereof is preferably a GaN film having an Ga face on the surface thereof among these. A group III nitride has a wurtzite structure, and generally has a polarity due to the asymmetry in the c-axis direction. The polar face of the group III nitride film grown in the c-axis direction on the group III element side constitutes the group III element face, and the polar face thereof on the nitrogen side constitutes the N face. As for GaN, the polar face of the GaN film grown in the c-axis direction on the Ga side constitutes the Ga face, and the polar face thereof on the nitrogen side constitutes the N face.

The N face has a larger etching rate to a KOH aqueous solution than the group III element face. Therefore, whether the surface of the group III nitride film is the group III element face or the N face can be determined, for example, by the difference in etching rate to a KOH aqueous solution. For example, in the case where the group III nitride film is immersed in a 2 mol/L KOH aqueous solution at 40°C for 45 minutes, the Ga face is not etched, whereas the N face is etched. Whether the surface of the GaN film is the Ga face or the N face can be determined by the presence or absence of etching.

### Step (B)

In the step (B), ion implantation is performed to the group III nitride film on at least one surface of both surfaces of the group III nitride film carrier, so as to form an ion-implanted region in the group III nitride film. The ion implantation is a method in which atoms or molecules to be implanted are ionized in vacuum, and accelerated to several keV to several MeV to implant to a solid. Examples of the ion to be implanted include a hydrogen ion and an argon (Ar) ion. The ion implantation may be performed, for example, with an ion implantation equipment. The ion implantation equipment includes a high energy accelerator and an isotope separator, which are downsized, and is constituted by an ion source, an accelerator, a mass separator, a beam scanner, an implantation chamber, and the like. The depth of the ion-implanted region can be regulated by the acceleration energy of the ion, the radiation dose thereof, and the like. The ion irradiated on the group III nitride film penetrates into the group III nitride film, and stops through loss of the energy thereof. Before performing the ion implantation, an extremely thin SiO₂ film may be formed on the surface of the group III nitride film for enhancing the uniformity of the ion implantation. The thickness of the SiO₂ film may be, for example, 200 to 1,000 nm.

### Step (C)

In the step (C), the group III nitride film having been subjected to the ion implantation of the group III nitride film carrier is adhered to a base substrate containing polycrystals containing a group III nitride as a major component, so as to bond the group III nitride film carrier to the base substrate. According to the procedure, the ion-implanted region of the group III nitride film can be bonded to the base substrate containing polycrystals containing a group III nitride as a major component, so as to perform the batch transfer thereof.

Before bonding the group III nitride film carrier, the surface of the base substrate may be polished with CMP or the like to smooth the surface of the base substrate. Before bonding the group III nitride film carrier, an SiO₂ film may be formed on the surface of the base substrate. In this case, also, before bonding the group III nitride film carrier, the SiO₂ film existing on the surface of the base substrate may be polished with CMP or the like to smooth the surface of the SiO₂ film. In the case where the surface of the base substrate or the surface of the SiO₂ film formed on the surface of the base substrate has poor smoothness, the entire surface of the group III nitride film carrier or the entire surface of the base substrate may not be bonded, and there are cases where only a part of the group III nitride film to be transferred is transferred to the base substrate, or the group III nitride film is not transferred to the base substrate. For enhancing the bond between the group III nitride film carrier and the base substrate, the group III nitride film carrier may be adhered to the base substrate under heating.

Examples of the group III nitride as the major component of the base substrate include AlN, GaN, and InN. The method for manufacturing a group III nitride substrate of the present invention can particularly favorably manufacture a GaN substrate, and therefore, the group III nitride of the base substrate containing polycrystals containing the group III nitride as a major component is preferably GaN among the above. The base substrate containing polycrystals containing a group III nitride as a major component is more preferably a polycrystalline GaN (P-GaN) substrate from the standpoint of the low cost thereof. The group III nitride of the group III nitride film having a group III element face on the surface thereof is preferably the same as the group III nitride as the major component of the base substrate.

The base substrate preferably has a thermal expansion coefficient that is the same as or is substantially the same as the target group III nitride film. In the case where the thermal expansion coefficient of the base substrate is largely different from the thermal expansion coefficient of the group III nitride film, warpage or cracks may occur in the group III nitride film in some cases. Therefore, it is preferred that the major component of the base substrate is a group III nitride as similar to the target group III nitride film, and the base substrate is a polycrystalline substrate due to the low cost thereof.

The base substrate can be produced by various production methods. However, the base substrate is preferably a substrate that is obtained by forming polycrystals on a PBN (pyrolytic boron nitride) substrate by a vapor phase epitaxy method. By forming the base substrate by a vapor phase epitaxy method, a base substrate having good quality with less impurities can be obtained. Since the PBN substrate has high purity, a base substrate having metal impurities in an extremely small amount can be obtained by forming polycrystals on the PBN substrate by a vapor phase epitaxy method. Since the PBN substrate has cleavability, the polycrystalline base substrate can be readily released from the PBN substrate after forming polycrystals on the PBN substrate by a vapor phase epitaxy method. Since the PBN substrate has cleavability, furthermore, the polycrystalline base substrate is released from the PBN substrate in occurrence of a large stress between the polycrystalline base substrate and the PBN substrate, and thereby a base substrate having good quality with less warpage can be obtained.

The vapor phase epitaxy method is preferably a THVPE method since the method achieves a large growing rate of the group III nitride film, and is an efficient and economically advantageous vapor phase epitaxy method. In the case where the base substrate needs to have a large strength, polycrystals are preferably formed by the THVPE method under reduced pressure. In the case where the base substrate does not need to have such a large strength, polycrystals are preferably formed by the THVPE method under ordinary pressure since a large growing rate of the group III nitride film can be obtained. In the THVPE method, for example, the process gas used may be gallium trichloride (GaCl₃) and ammonia (NH₃), and the carrier gas used may be nitrogen (N₂).

### Step (D)

In the step (D), the group III nitride film carrier is spaced from the base substrate to transfer the ion-implanted region of the group III nitride film to the base substrate, so as to form a group III nitride film having an N face on the surface thereof on the base substrate. The surface of the group III nitride film on the side of the base substrate is the group III element face, and therefore the surface of the group III nitride film transferred to the base substrate is the opposite surface thereto, i.e., the N face. According to the procedure, the group III nitride film having an N face on the surface thereof can be readily formed on the base substrate.

The ion-implanted region of the group III nitride film is transferred to the base substrate, and therefore the thickness of the group III nitride film transferred to the base substrate is determined by the depth of the ion-implanted region of the group III nitride film. Specifically, in the case where the depth of the ion-implanted region of the group III nitride film is increased, the group III nitride film transferred to the base substrate becomes thicker, whereas in the case where the depth of the ion-implanted region of the group III nitride film is decreased, the group III nitride film transferred to the base substrate becomes thinner. The thickness of the group III nitride film transferred to the base substrate is preferably 50 to 2,000 nm. In the case where the thickness of the group III nitride film is 50 nm or more, the group III nitride film can sufficiently exhibit the function as a seed crystal, and a group III nitride film with less defects can be formed in the step (E) described later. In the case where the thickness of the group III nitride film is 2,000 nm or less, the cost required for operating the ion implantation equipment can be reduced by suppressing the output power of the ion implantation equipment, and the manufacturing cost of the group III nitride substrate can be reduced.

The group III nitride film carrier after transferring the group III nitride film to the base substrate can be reused for the transfer of a group III nitride film to the base substrate. In this case, the group III nitride film on the opposite side to the surface having been used for the transfer of the group III nitride film to the substrate is preferably transferred to the base substrate from the standpoint of the reduction of warpage of the group III nitride film carrier. In the case where the group III nitride film carrier having been used for the transfer of the group III nitride film to the base substrate is reused multiple times for the transfer of a group III nitride film to the base substrate, the group III nitride film provided on one surface of the group III nitride film carrier and the group III nitride film provided on the other surface of the group III nitride film carrier are preferably used alternately from the same standpoint.

### Step (E)

In the step (E), a group III nitride film is formed on the group III nitride film having an N face on the surface thereof on the base substrate by a THVPE method, and the crystal growth of the group III nitride crystal is continued until the group III nitride film becomes a thick film, so as to produce a thick film of a group III nitride film. The thick film of the group III nitride film can be used as a group III nitride substrate. According to the procedure, the increase in thickness (increase in length) of a group III nitride single crystal, which has been difficult to achieve, can be realized. Since the group III nitride film is formed on the group III nitride film having an N face on the surface thereof by a THVPE method, the crystal growth rate of the group III nitride crystal can be further increased, and a thick group III nitride film can be formed by a single transfer operation of the group III nitride film. Accordingly, the method for manufacturing a group III nitride substrate of the present invention is efficient and economical, and thus is a significantly favorable film forming method.

Furthermore, since the base substrate containing polycrystals containing a group III nitride as a major component is used, the thermal expansion coefficient of the base substrate is close to the thermal expansion coefficient of the group III nitride film formed on the group III nitride film having an N face on the surface thereof. Accordingly, the deterioration of the characteristics of the group III nitride film due to warpage and thermal stress of the base substrate in the film formation or after the film formation can be suppressed. Consequently, a group III nitride film having a high quality can be obtained, and furthermore the increase in thickness (increase in length) of a group III nitride single crystal, which has been difficult to achieve, can be facilitated. In addition, the base substrate, the group III nitride transferred on the base substrate, and the group III nitride film formed on the group III nitride film having an N face on the surface thereof are formed of the similar substances, and therefore the problem caused by metal impurities is difficult to occur. Consequently, a group III nitride film having a further high quality can be obtained.

Examples of the group III nitride of the group III nitride film formed on the group III nitride film having an N face on the surface thereof include AlN, GaN, and InN. The method for manufacturing a group III nitride substrate of the present invention can particularly favorably manufacture a GaN substrate, and therefore the group III nitride film formed on the group III nitride film having an N face on the surface thereof is preferably a GaN film among the above. The group III nitride of the group III nitride film formed on the group III nitride film having an N face on the surface thereof is preferably similar to the group III nitride of the group III nitride film having an N face on the surface thereof.

The present invention provides a manufacturing method that is favorable for a group III nitride substrate, and a substrate obtained by the manufacturing method. The group III nitride of the group III nitride substrate may be a group III nitride having a two-component system or a group III nitride having a multicomponent system, such as a three-component system, obtained by adding Al, In, Ga, and the like, for enhancing the characteristics of the substrate. Examples of the group III nitride of this type include AlₓGa₁₋ₓN, InₓGa₁₋ₓN, and AlₓIn_{y}Ga_{1-x-y}N. The group III nitride substrate may further contain a dopant, such as Zn, Cd, Mg, and Si, as needed.

### [Group III Nitride Substrate]

The group III nitride substrate of the present invention is manufactured by the method for manufacturing a group III nitride substrate of the present invention. Therefore, the group III nitride substrate of the present invention has a large diameter and a high quality.

### Examples

The present invention will be described more specifically with reference to examples and comparative examples below, but the present invention is not limited to the examples.

### [Example 1]

### (0) Preparation of Base Substrate

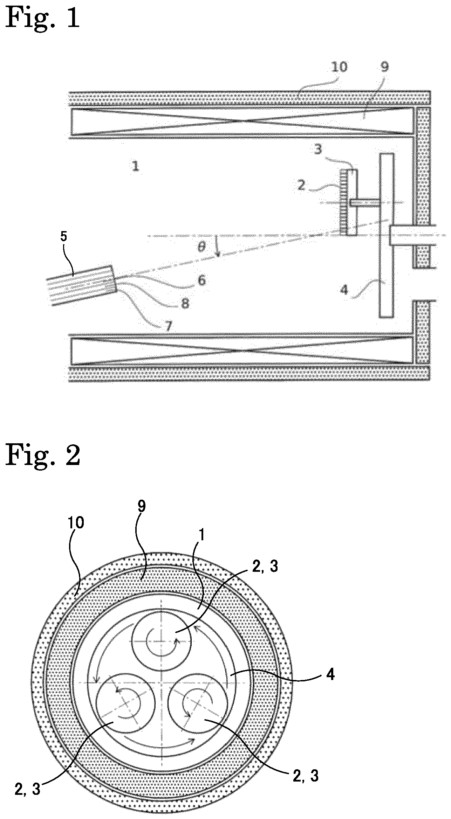

The production of a base substrate in Example 1 will be described with reference to Figs. 1 and 2. In a stainless steel reaction apparatus (the inner surface of which had been very thinly coated with zirconia though thermal spraying) having a water cooling jacket and an exhaust port, with an inner diameter of 1,500 mm and a height of 1,800 mm, which is not shown in the figures, a mat thermal insulating material 10 was inserted, and therein a heating device 9 having a SiC heater in a cylindrical rod form (inner diameter: 1,000 mm, height: 1,300 mm) and a gas supplying tube 5 (including a center tube 6 (inner diameter: 30 mm), a second tube 8 (inner diameter: 40 mm), and an outermost tube 7 (inner diameter: 50 mm), which were formed of the same material as the reaction apparatus) were provided. A susceptor revolution fixture 4 of PBN (pyrolytic boron nitride)-coated graphite having a diameter of 520 mm, having housed therein three susceptors 3 formed of PBN each having a diameter of 170 mm disposed by 120° was prepared. Under heating the susceptor surface to 1,250°C with a heater, the susceptor revolution fixture 4 was rotated at 10 rpm to revolute the susceptors 3, and simultaneously the susceptors 3 each were rotated at 30 rpm with the force of the revolution gears. After confirming that the temperature and the revolution and rotation of the susceptors were stabilized, the THVPE reaction was started at ordinary pressure by supplying GaCl₃ gas to an interior 1 of the reaction apparatus through the center tube 6 of the triple tube, NH₃ gas thereto through the outermost tube 7 thereof, and N₂ gas thereto through the second tube 8 between the center tube 6 and the outermost tube 7. As the growth of a GaN film, reaction was performed at a film growth rate of approximately 300 µm/h for 4 hours, and polycrystals 2 of GaN were formed on the susceptors 3.

After cooling, the resulting GaN polycrystals were released from the PBN susceptors 3 at the portion of PBN where delamination readily occurred. The polycrystals thus released were formed into a disk having a diameter of 155 mm with a lathe. The disk was polished with a fixed whetstone to remove the PBN layer of the disk completely. Furthermore, both surfaces of the disk were polished with the whetstone until the thickness of the disk became 750 µm. The surface of the polycrystals of GaN was mirror finished by CMP (chemical mechanical polishing) to smooth the surface of the disk, thus preparing a polycrystalline base substrate of GaN. The thermal expansion coefficient difference of the polycrystalline base substrate of GaN measured was approximately 5.2 ppm/K. The thermal expansion coefficient of a GaN single crystal is approximately 5.6 ppm/K at 500°C.

A SiO₂ film was formed on the upper surface of the base substrate by stacking SiO₂ to 0.5 µm with a plasma CVD equipment, and the SiO₂ film was lightly polished by CMP to make the thickness of the SiO₂ film to 0.4 µm.

### (1) Step of forming GaN film on Both Surfaces of Substrate

GaN films were formed on both surfaces of a Si <111> substrate having a diameter of 150 mm and a thickness of 625 µm by the ordinary MOCVD method. The thickness of the GaN film on the front surface of the Si <111> substrate was 5.7 µm, and the thickness of the GaN film on the back surface thereof was 5.8 µm. On both the front surface and the back surface of the Si <111> substrate, the surface of the GaN film was a Ga face. The curvature radius of the Si <111> substrate after forming the film only on the front surface of the substrate was 3.5 m. However, the curvature radius of the Si <111> substrate after further forming the film on the back surface of the substrate was 31 m, and substantially no warpage was found in the substrate.

### (2) Step of Ion Implantation to GaN Film

Hydrogen ion was implanted to the GaN film (thickness: 5.7 µm) on the front surface of the Si <111> substrate to a depth of 0.5 µm.

### (3) Step of Batch Transfer of GaN Film to Base Substrate

The GaN film having been subjected to the ion implantation was transferred in a batchwise manner to the base substrate prepared above. The surface of the GaN film transferred to the base substrate by the transfer was an N face. The GaN film was used as a seed crystal substrate for the target GaN film. The GaN film remaining on the back surface of the Si <111> substrate was reused.

### (4) Step of stacking and increase in thickness of GaN Film

With the same apparatus as used in the production of the base substrate under the same condition as for the base substrate, a THVPE reaction was continued for 72 hours with the seed crystal substrate, so as to form a GaN single crystal on the seed substrate. The resulting GaN single crystal had no warpage nor deformation even after cooling, and a large sized and thick GaN single crystal was obtained. The GaN single crystal was worked into a diameter of 150 mm and a thickness of approximately 15 mm with a lathe, and then was cut with diamond and polished on both surfaces thereof, so as to produce 15 plies of GaN single crystal substrates having a diameter of 150 mm and a thickness of 625 µm of Example 1.

### (5) Evaluation of resulting GaN Single Crystal Substrate

The uppermost GaN substrate among the resulting 15 plies of GaN substrates (i.e., the GaN substrate most remote from the seed substrate) had an FWHM (full width half maximum) of the X-ray rocking curve of the (002) face as an average of arbitrary three points of 35 arcsec and a dispersion thereof of 1 arcsec, which meant that the substrate was a substrate having extremely good crystallinity. The lowermost GaN substrate among the resulting 15 plies of substrates (i.e., the GaN substrate most close to the seed substrate) had an FWHM of the X-ray rocking curve of the (002) face as an average of arbitrary three points of 80 arcsec and a dispersion thereof of 4 arcsec, which meant that the substrate was a substrate having extremely good crystallinity although the crystallinity thereof was slightly inferior to the uppermost GaN substrate. The results of chemical analysis of the surfaces of the substrates revealed that the metal contamination in the GaN substrates was lower than the detection limit for both the uppermost GaN substrate and the lowermost GaN substrate.

The results of observation of stacking defects with a monochromatic cathode luminescence image revealed that no stacking defect was found in the uppermost GaN substrate. On the other hand, only slight stacking defects were found in the lowermost GaN substrate, but the extent thereof was equivalent to a GaN substrate by the MOCVD method. The results showed that the GaN substrate crystal of Example 1 was a GaN crystal substrate having a large diameter and a high quality.

### [Comparative Example 1]

The film formation method for forming the GaN films on both surfaces of the Si <111> substrate was changed from the MOCVD method to the THVPE method. The surface of the GaN film obtained by the MOCVD method was a Ga face, whereas the surface of the GaN face obtained by the THVPE method was an N face. Accordingly, the surface of the GaN film after the ion implantation and the batch transfer to the base substrate became a Ga face. The GaN film formed through THVPE reaction mismatched the Ga face of the GaN film. Accordingly, for providing a GaN film having an N face on the surface thereof for performing increase in thickness (increase in length) of a GaN film by the THVPE method, it was necessary to transfer the GaN film to another Si <111> substrate and to transfer the GaN film having been transferred to the Si <111> substrate further to the base substrate, the operations of which were not practical.

### [Example 2]

### (0) Preparation of Base Substrate

The reaction in Example 1 was performed under a reduced pressure of 30 Torr for 78 hours, followed by grinding and polishing, to produce a polycrystalline GaN base substrate having a thickness of 625 µm.

### (1) Step of forming GaN film on Both Surfaces of Substrate

GaN films were formed on both surfaces of a C face sapphire substrate having a diameter of 150 mm and a thickness of 625 µm by the HVPE method. The thickness of the GaN film on the front surface of the C face sapphire substrate was 8.5 pm, and the thickness of the GaN film on the back surface thereof was 8.4 µm. On both the front surface and the back surface of the C face sapphire substrate, the surface of the GaN film was a Ga face. The curvature radius of the C face sapphire substrate after forming the film only on the front surface of the substrate was 2.5 m. However, the curvature radius of the C face sapphire substrate after further forming the film on the back surface of the substrate was 25 m, and the warpage of the substrate was significantly small.

### (2) Step of Ion Implantation to GaN Film

Hydrogen ion was implanted to the GaN film (thickness: 8.5 µm) on the surface of the C face sapphire substrate to a depth of 0.6 µm.

### (3) Step of Batch Transfer of GaN Film to Base Substrate

The GaN film having been subjected to the ion implantation was transferred in a batchwise manner to the base substrate prepared above. The surface of the GaN film transferred to the base substrate by the transfer was an N face. The GaN film was used as a seed crystal substrate for the target GaN film. The GaN film remaining on the back surface of the C face sapphire substrate was reused.

### (4) Step of stacking and increase in thickness of GaN Film

With the same apparatus as used in the production of the base substrate under the same condition as for the base substrate, a THVPE reaction was continued for 72 hours with the seed crystal substrate, so as to form a GaN single crystal on the seed substrate. The resulting GaN single crystal had no warpage nor deformation even after cooling, and a large sized and thick GaN single crystal was obtained. The GaN single crystal was worked into a diameter of 150 mm and a thickness of approximately 15 mm with a lathe, and then was cut with diamond and polished on both surfaces thereof, so as to produce 15 plies of GaN single crystal substrates having a diameter of 150 mm and a thickness of 625 µm of Example 1.

### (5) Evaluation of resulting GaN Single Crystal Substrate

The uppermost GaN substrate among the resulting 15 plies of GaN substrates (i.e., the GaN substrate most remote from the seed substrate) had an FWHM (full width half maximum) of the X-ray rocking curve of the (002) face as an average of arbitrary three points of 45 arcsec and a dispersion thereof of 2 arcsec, which meant that the substrate was a substrate having extremely good crystallinity. The lowermost GaN substrate among the resulting 15 plies of substrates (i.e., the GaN substrate most close to the seed substrate) had an FWHM of the X-ray rocking curve of the (002) face as an average of arbitrary three points of 95 arcsec and a dispersion thereof of 6 arcsec, which meant that the substrate was a substrate having good crystallinity although the crystallinity thereof was slightly inferior to the uppermost GaN substrate. The results of chemical analysis of the surfaces of the substrates revealed that the metal contamination in the GaN substrate was lower than the detection limit for both the uppermost GaN substrate and the lowermost GaN substrate.

The results of observation of stacking defects with a monochromatic cathode luminescence image revealed that no stacking defect was found in the uppermost GaN substrate. On the other hand, only slight stacking defects were found in the lowermost GaN substrate, but the extent thereof was equivalent to a GaN substrate by the MOCVD method. The results showed that the GaN substrate crystal of Example 2 was a GaN crystal substrate having a large diameter and a high quality.

### Reference Sign List

1: Interior of reaction equipment
2: Polycrystals of GaN
3: Susceptor
4: Susceptor revolution fixture
5: Gas supplying tube
6: Center tube
7: Outermost tube
8: Second tube
9: Heater
10: Thermal insulating material

## Claims

1. A method for manufacturing a group III nitride substrate, comprising:
a step of forming group III nitride films having a group III element face on a surface thereof, on both surfaces of a substrate selected from the group consisting of a Si <111> substrate, a sapphire substrate, a SiC substrate, a GaAs substrate, and a SCAM (ScAlMgO₄) substrate, so as to produce a group III nitride film carrier;
a step of performing ion implantation to the group III nitride film on at least one surface of both surfaces of the group III nitride film carrier, so as to form an ion-implanted region in the group III nitride film;
a step of adhering the group III nitride film having been subjected to the ion implantation of the group III nitride film carrier to a base substrate containing polycrystals containing a group III nitride as a major component, so as to bond the group III nitride film carrier to the base substrate;
a step of spacing the group III nitride film carrier from the base substrate to transfer the ion-implanted region of the group III nitride film to the base substrate, so as to form a group III nitride film having an N face on a surface thereof on the base substrate; and
a step of forming a group III nitride film on the group III nitride film having an N face on a surface thereof on the base substrate by a THVPE method, so as to produce a thick film of a group III nitride film.

2. The method for manufacturing a group III nitride substrate according to claim 1, wherein the group III nitride film having a group III element face on a surface thereof is a GaN film having a Ga face on a surface thereof.

3. The method for manufacturing a group III nitride substrate according to claim 1 or 2, wherein the base substrate is a polycrystalline GaN (P-GaN) substrate.

4. The method for manufacturing a group III nitride substrate according to any one of claims 1 to 3, wherein the group III nitride film formed on the group III nitride film having an N face on a surface thereof on the base substrate is a GaN film.

5. The method for manufacturing a group III nitride substrate according to any one of claims 1 to 4, wherein the base substrate is a substrate that is obtained by forming the polycrystals on a PBN substrate by a vapor phase epitaxy method.

6. The method for manufacturing a group III nitride substrate according to claim 5, wherein the vapor phase epitaxy method is a THVPE method.

7. The method for manufacturing a group III nitride substrate according to any one of claims 1 to 6, wherein
the step of producing the group III nitride film carrier includes forming the group III nitride films having a group III element face on a surface thereof, on both surfaces of the substrate to have thicknesses that are substantially the same as each other, by an MOCVD method, and
the group III nitride film carrier produced by the step of producing the group III nitride film carrier has a curvature radius of 10 m or more.

8. A group III nitride substrate that is manufactured by the method for manufacturing a group III nitride substrate according to any one of claims 1 to 7.
